Europäisches Patentamt

European Patent Office

Office européen des brevets

(11) Numéro de publication: **0 464 926 A2**

# DEMANDE DE BREVET EUROPEEN

(21) Numéro de dépôt: **91201637.5**

(22) Date de dépôt: **27.06.91**

(51) Int. Cl.5: **H05K 3/00**

(30) Priorité: **03.07.90 FR 9008376**

(43) Date de publication de la demande:
**08.01.92 Bulletin 92/02**

(84) Etats contractants désignés:
**CH DE FR GB IT LI**

(71) Demandeur: **PHILIPS COMPOSANTS**
**117, quai du Président Roosevelt**
**F-92130 Issy les Moulineaux(FR)**

(84) **FR**

Demandeur: **N.V. Philips'**
**Gloeilampenfabrieken**
**Groenewoudseweg 1**

**NL-5621 BA Eindhoven(NL)**
(84) **CH DE GB IT LI**

(72) Inventeur: **Chapron, Jean-Claude, Société**
**Civile S.P.I.D.**
**156, Boulevard Haussmann**
**F-75008 Paris(FR)**
Inventeur: **Sorel, Alain, Société Civile S.P.I.D.**
**156, Boulevard Haussmann**
**F-75008 Paris(FR)**

(74) Mandataire: **Caron, Jean et al**
**Société Civile S.P.I.D. 156, Boulevard**
**Haussmann**
**F-75008 Paris(FR)**

(54) **Procédé et dispositif pour l'assemblage de plaques de circuits imprimés.**

(57) Un dispositif pour la mise en oeuvre du procédé est équipé d'une table (14) sur laquelle avance pas à pas un paquet (1) de plaques assemblées par des moyens provisoires. Un foret 7, une pipette doseuse 8 pour déposer une quantité prédéterminée d'un produit accélérateur de polymérisation, et une autre pipette doseuse 9 pour déposer une quantité prédéterminée de colle à prise quasi-instantannée sont prévus. Les organes 7, 8, 9 sont disposés sur une même ligne parallèle à l'avance du paquet (1), et espacés horizontalement d'une distance égale à ladite avance. Ainsi un même point du paquet 1 sera positionné tour à tour sous le foret 7, puis sous la pipette 8 (trou 11), puis sous la pipette 9 (trou 12).

A chaque arrêt entre deux phases d'avance, le foret descend et les pipettes débitent un peu de produit. Ainsi, on a successivement perçage d'un trou, puis dépot d'accélérateur et dépot de colle dans le trou. La colle est à prise quasi-instantanée, et de ce fait le paquet est assemblé de façon rigide dès sa sortie du dispositif.
Application: Assemblage de paquets constitués de plaques destinées à la réalisation de circuits imprimés, empilées les uns sur les autres pour être percées ensemble.

FIG.2

La présente invention concerne un procédé pour l'assemblage de paquets constitués de plaques, destinées à la réalisation de circuits imprimés, plaques identiques empilées les uns sur les autres pour être percées ensemble.

Elle concerne également un dispositif pour l'assemblage de paquets constitués de plaques, destinées à la réalisation de circuits imprimés, plaques identiques empilées les unes sur les autres pour être percées ensemble.

Dans l'art antérieur on utilisait, pour le maintien de circuits imprimés, des chevilles métalliques enfoncées à force dans deux trous situés à deux extrémités opposées du circuit, comme les chevilles 14 de la figure 2 du document US-A-4,019,826. Ceci présentait plusieurs inconvénients : les chevilles dépassant de la surface extérieure des paquets, l'empilage de ceux-ci était impossible, à moins de placer les paquets alternativement dans deux directions perpendiculaires, ce qui complique la manutention. En outre, les dimensions des circuits imprimés devenant de plus en plus grandes (on atteint maintenant 700 X 535 mm), l'assemblage par deux points seulement n'est plus satisfaisant, et les circuits imprimés ont tandance à ne pas être appliqués assez intimement les uns sur les autres en certaines de leurs parties, ce qui entraine le risque d'avoir des bavures de cuivre lors du perçage, et des mouvements relatifs incontrôlables avec pour conséquence une imprécision de la position des trous.

La présente invention a pour objet de procurer un moyen et un dispositif pour l'assemblage de tels paquets, qui procure des paquets facilement empilables, afin de simplifier leur manutention, et avec lesquels les circuits imprimés soient parfaitement solidarisés les uns par rapport aux autres, afin d'éviter que certaines parties des circuits imprimés ne bougent par rapport à d'autres sous l'effet des efforts dûs au perçage.

A cet effet, le procédé selon l'invention est remarquable en ce que, les plaques étant maintenues provisoirement assemblées par un moyen quelconque, on fixe les plaques entre elles par collage au moyen d'une pluralité de liens de colle à prise rapide disposés dans la région périphérique des plaques.

Il est vrai que le document US-A-4,019,826 cité plus haut enseigne l'utilisation de bandes d'adhésif. Mais il s'agit de maintenir une tôle à la surface d'un panneau de circuit imprimé pour le protéger, et non de maintenir un paquet de circuits devant être solidarisés pour être manipulés ensemble. Le problème technique est donc totalement différent de celui que résout la présente invention.

Dans une forme de réalisation, les liens selon l'invention sont réalisés par des traits de colle déposés à intervalles réguliers sur la tranche des paquets de plaques.

Dans une autre forme de réalisation, les plaques étant rectangulaires, on y perce d'abord une ligne de trous le long de chacun de deux cotés parallèles, puis on fait couler la colle dans les trous.

Dans cette forme de réalisation , le procédé a en outre l'avantage que les trous (débouchés entre temps) peuvent être utilisés pour le positionnement des circuits imprimés.

Un dispositif selon l'invention est remarquable en ce qu'il comporte des moyens pour maintenir les plaques provisoirement assemblées en un paquet, des moyens pour faire avancer un paquet pas à pas, et des moyens pour déposer de la colle à prise rapide dans la région périphérique des plaques.

Dans une forme de réalisation particulière, le dispositif selon l'invention est remarquable en ce que, les plaques étant rectangulaires et préalablement percées d'une ligne de trous le long de chacun de deux cotés parallèles, il comporte des moyens pour déposer de la colle à prise rapide dans lesdits trous.

Il est avantageux de réaliser le perçage des trous sur le même dispositif qui réalise le collage, et à cet effet, le dispositif est avantageusement muni de moyens de perçage de trous le long de chacun de deux cotés parallèles des plaques, et de moyens pour déposer de la colle à prise rapide dans lesdits trous.

Afin de faciliter le remplissage des trous et de définir avec précision le volume de colle déposé, le dispositif est avantageusement muni d'une surface de support des paquets faite d'un matériau sur lequel la colle n'adhère pas, et cette surface est percée, pour évacuer de l'air, de trous de diamètre plus petits que ceux des trous percés dans les plaques, situés au droit des positions où sont les trous des plaques au moment où la colle y est introduite.

La description qui va suivre, en regard des dessins annexés décrivant des exemples non limitatifs fera bien comprendre comment l'invention peut être réalisée.

La figure 1 représente en perspective un paquet constitué de plaques destinées à la réalisation de circuits imprimés.

La figure 2 représente en coupe une partie d'un dispositif pour l'assemblage de paquets de plaques.

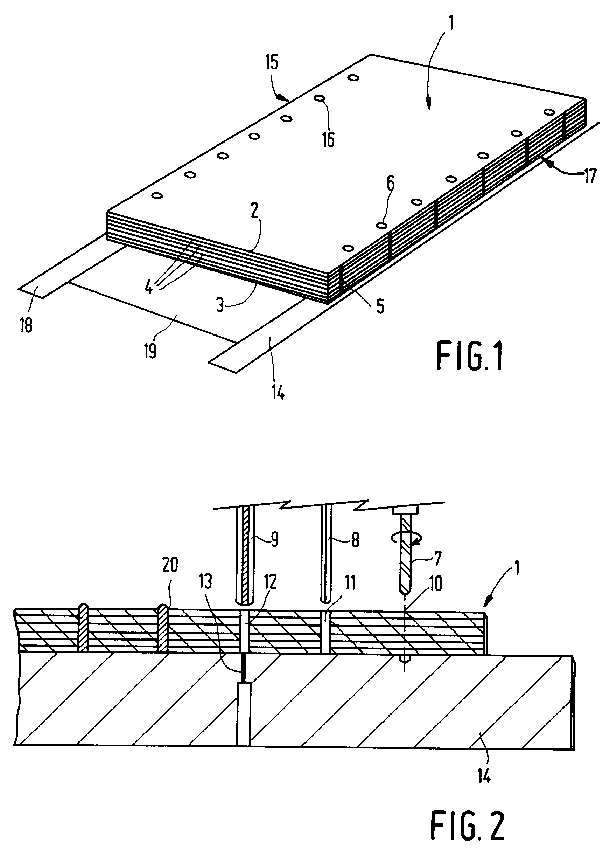

Sur la figure 1, le paquet 1 est constitué de plaques 4 destinées à la réalisation de circuits imprimés. Ce sont par exemple des plaques cuivrées "plein cuivre" c'est à dire dont les motifs de pistes conductrices n'ont pas encore été gravés. Après le perçage, les parois des trous ainsi percés seront recouverts de cuivre, puis sera réalisée la gravure des pistes. Les plaques sont identiques entre elles et sont empilées les unes sur les autres pour être percées ensemble. Elles sont en outre placées en sandwich entre une plaque 2 dite d'entrée qui est faite d'un matériau tendre (bakélite) pour faciliter l'entrée d'un foret de perçage, et une plaque 3 dite de sortie destinée à refroidir le foret et à éviter les bavures.

Pour solidariser les plaques du paquet 1, on peut déposer des filets de colle en forme de trait, tel que celui qui est référencé 5, en déplaçant verticalement un embout débiteur de colle (non représenté) le long de la tranche du paquet. Avant de déposer les traits de colle 5, on a pulvérisé ("spray") un produit accélérateur sur les tranches des paquets de plaques.

Dans une autre variante du procédé, qui est celle préférée, les plaques 2, 3, 4 étant rectangulaires, on y perce d'abord deux lignes de trous le long des deux cotés parallèles 15 et 17. Pour ne pas charger la figure, un seul trou de chaque ligne est référencé : l'un est référencé 6 le long du coté 17, et un autre est référencé 16 le long du coté parallèle 15. Après le perçage des trous, on y fait couler un produit accélérateur, et ensuite de la colle à prise rapide.

Bien que la variante du procédé qui consiste à déposer des traits de colle et celle avec des trous soient illustrées sur la même figure 1, il est bien évident qu'en pratique on utilisera soit l'une, soit l'autre des variantes du procédé.

Le dispositif pour la mise en oeuvre du procédé est équipé d'une table, qui est constituée d'une partie fixe et d'une partie mobile. La partie centrale du paquet 1 est posée sur la partie mobile (dont la surface supérieure est représentée en 19) qui avance pas à pas entre deux éléments fixes (dont la surface supérieure est représentée en 18, 14) sur lesquelles glissent les rangées de trous 6, 16. La partie mobile est munie de moyens pour entraîner les plaques et pour les maintenir provisoirement assemblées en un paquet. Ces moyens ne sont pas représentés, parcequ'il en existe plusieurs types au choix, tous bien connus de l'homme du métier, tels que serre-flancs, pinces, machoires, brides, etc.

Sur la figure 2 le paquet 1 est vu latéralement, coupé dans le plan des axes de la rangée de trous 6. Au dessus de l'élément fixe 14 de la table (et aussi, bien entendu, au dessus de l'autre élément fixe 18 non visible sur la figure 2) sont installés des moyens de perçage constitués par un foret 7 entraîné en rotation par des moyens connus non représentés, une pipette doseuse 8 pour déposer une quantité prédéterminée d'un produit accélérateur de polymérisation (par exemple le produit connu sous la référence commerciale "Loctite 745"), et une autre pipette doseuse 9 pour déposer une quantité prédéterminée de colle à prise rapide (par exemple la colle à prise quasi-instantannée connue sous la référence commerciale "Loctite 422"). Des pipettes doseuses sont en vente dans le commerce. Les organes 7, 8, 9 sont disposés sur une même ligne parallèle à l'avance de la partie mobile de la table (pas à pas vers la gauche sur la figure), et espacés horizontalement d'une distance égale à un pas de l'avance. Ainsi un même point du paquet 1 sera positionné tour à tour sous le foret 7, puis sous la pipette 8 (trou 11), puis sous la pipette 9 (trou 12).

A chaque arrêt entre deux phases d'avance du paquet, le foret descend et les pipettes débitent un peu de produit. Ainsi, on a successivement perçage, puis dépôt d'accélérateur et dépôt de colle dans le trou ainsi percé. La colle est à prise quasi-instantanée, et de ce fait le paquet est assemblé de façon rigide dès sa sortie du dispositif.

Les parties fixes 14 et 18, ou au moins leur surface supérieure sur laquelle le paquet glisse, sont en polytétrafluoréthylène ("téflon"), ou en un autre matériau équivalent sur lequel la colle utilisée n'adhère pas. En outre sous chaque pipette débitrice de colle est percé un trou 13. Ce trou est donc placé au droit de la position du trou 12 percé dans les plaques du paquet 1 au moment où la colle y est introduite. Il a un diamètre plus petit que celui des trous percés dans les plaques du paquet 1. Son rôle est de permettre l'évacuation de l'air contenu dans le trou lorsque la colle y descend tout en étant de diamètre trop faible pour que la colle y pénètre, grâce à la capillarité.

La référence 20 indique un trou terminé rempli de colle. Pour des plaques de 700 X 525 mm, on peut par exemple prévoir des trous espacés d'environ 8 cm l'un de l'autre, et dont le diamètre est d'environ 1,5 mm. Les trous 13 dans la table peuvent avoir alors un diamètre d'environ 1mm. Pour des paquets contenant deux à quatre plaques d'épaisseur unitaire 1,6 mm et les deux plaques d'entrée et de sortie (épaisseur totale maximale d'environ 8 mm), le temps de cycle est d'environ 2 sec, pour le perçage réalisé simultanément avec le dépôt des produits, et ainsi le temps total pour un paquet entier comportant sept trous de chaque coté, est de 14 sec.

Lorsque l'on ne souhaite plus traiter les plaques par paquets, il est possible de les désolidariser en perçant à nouveau dans les trous, pleins de colle polymérisée, par exemple avec un foret de 2 mm, ceci pouvant notamment être réalisé sur le même dispositif, en désactivant les pipettes doseuses. Les trous ainsi obtenus peuvent avantageusement être utilisés pour assurer le repérage en position des plaques dans les opérations de fabrication ultérieures (sérigraphie ou photographie, galvanoplastie, etc).

## Revendications

1.  Procédé pour l'assemblage de paquets constitués de plaques, destinées à la réalisation de circuits imprimés, plaques identiques empilées les unes sur les autres pour être percées ensemble, caractérisé en ce que, les plaques étant maintenues provisoirement assemblées par un moyen quelconque, on fixe les plaques entre elles par collage au moyen d'une pluralité de liens de colle à prise rapide disposés dans la région périphérique des plaques.

2.  Procédé selon la revendication 1, caractérisé en ce que les liens sont réalisés par des traits de colle déposés à intervalles réguliers sur la tranche des paquets de plaques.

3.  Procédé selon la revendication 1, caractérisé en ce que, les plaques étant rectangulaires, on y perce d'abord une ligne de trous le long de chacun de deux cotés parallèles, puis on fait couler la colle dans les trous.

4.  Dispositif pour l'assemblage de paquets constitués de plaques, destinées à la réalisation de circuits imprimés, plaques identiques empilées les unes sur les autres pour être percées ensemble, caractérisé en ce qu'il comporte des moyens pour maintenir les plaques provisoirement assemblées en un paquet, des moyens pour faire avancer un paquet pas à pas, et des moyens pour déposer de la colle à prise rapide sur la tranche d'un paquet.

5.  Dispositif pour l'assemblage de paquets constitués de plaques, destinées à la réalisation de circuits imprimés, plaques rectangulaires identiques empilées les unes sur les autres pour être percées ensemble, caractérisé en ce qu'il comporte des moyens pour maintenir les plaques provisoirement assemblées en un paquet, des moyens pour faire avancer un paquet pas à pas et, les plaques étant préalablement percées d'une ligne de trous le long de chacun de deux cotés parallèles, des moyens pour déposer de la colle à prise rapide dans lesdits trous.

6.  Dispositif pour l'assemblage de paquets constitués de plaques, destinées à la réalisation de circuits imprimés, plaques rectangulaires identiques empilées les unes sur les autres pour être percées ensemble, caractérisé en ce qu'il comporte des moyens pour maintenir les plaques provisoirement assemblées en un paquet, des moyens pour faire avancer un paquet pas à pas, des moyens de perçage de trous le long de chacun de deux cotés parallèles des plaques, et des moyens pour déposer de la colle à prise rapide dans les trous réalisés par lesdits moyens de perçage.

7.  Dispositif selon l'une des revendications 5 ou 6, caractérisé en ce qu'il est muni d'une surface de support des paquets faite d'un matériau sur lequel la colle n'adhère pas.

8.  Dispositif selon l'une des revendications 5 ou 6, caractérisé en ce qu'il est muni d'une surface de support des paquets qui est percée, pour évacuer de l'air, de trous de diamètre plus petits que ceux des trous percés dans les plaques, situés au droit des positions où sont les trous des plaques au moment où la colle y est introduite.

FIG.1

FIG. 2